# EUROPÄISCHE PATENTSCHRIFT

(11) **EP 2 356 722 B1**
(45) Veröffentlichungstag und Bekanntmachung des Hinweises auf die Patenterteilung: **30.03.2016**
(21) Anmeldenummer: 09744334.5
(22) Anmeldetag: 26.10.2009
(51) Int. Cl.: H01R 12/58, H01R 12/70, H01R 103/00, H01R 24/50, H01R 13/518, H01R 43/16

(54) **STECKVERBINDER FÜR SCHALTUNGSPLATINEN**
PLUG CONNECTOR FOR CIRCUIT BOARDS
CONNECTEUR ENFICHABLE POUR CARTES DE CIRCUITS

(30) Priorität: 03.11.2008 DE 202008014542 U
(43) Veröffentlichungstag der Anmeldung: 17.08.2011
(73) Patentinhaber: Rosenberger Hochfrequenztechnik GmbH & Co. KG, 83413 Fridolfing (DE)
(72) Erfinder: ZEBHAUSER, Martin, 83410 Laufen (DE); BLACKBORN, Willem, 83334 Inzell (DE); KÖBELE, Ulrich, 83454 Aufham (DE)
(74) Vertreter: Zeitler Volpert Kandlbinder Patent- und Rechtsanwälte Partnerschaft mbB
(86) Internationale Anmeldenummer: PCT/EP2009/007651
(87) Internationale Veröffentlichungsnummer: WO 2010/060511

(56) Entgegenhaltungen:
- EP-A- 0 936 702
- EP-A- 1 109 259
- DE-A1- 4 312 091
- DE-C1- 19 720 678
- US-A- 5 215 470
- US-A- 5 405 267
- US-A1- 2005 221 673

## Beschreibung

Die vorliegende Erfindung betrifft einen Leiterplattenmehrfachsteckverbinder zum Befestigen auf einer Leiterplatte mit einem Halterungsteil und wenigstens zwei Kontaktteilen, die jeweils ein Steckteil zum steckenden Verbinden mit einem komplementären Steckteil eines Steckverbinders aufweisen, wobei in dem Halterungsteil für jedes Kontaktteil eine Öffnung ausgebildet ist und jedes Kontaktteil mit dem Steckteil durch eine der Öffnungen greift und an dem Halterungsteil mechanisch befestigt ist, wobei jedes Kontaktteil an einer der Leiterplatte zugewanden Seite wenigstens ein Kontaktelement zum Herstellen eines elektrischen Kontaktes mit einem Leiter der Leiterplatte aufweist, gemäß dem Oberbegriff des Anspruchs 1. Die Erfindung betrifft ferner eine Leiterplatte mit einer elektronischen Schaltung und einem auf der Leiterplatte angeordneten und elektrisch mit der elektronischen Schaltung verbundenem Leiterplattenmehrfachsteckverbinder, gemäß dem Oberbegriff des Anspruchs 15.

Aus der DE 43 12 091 A1 ist ein Leiterplattensteckverbinder bekannt, der eine Schlitzöffnung aufweist, so dass ein flacher platinenförmiger Leiterbahnbereich einer Leiterplatine in diese Öffnung eingeführt werden kann. Auf dem Leiterbahnbereich verlaufen mehrere parallele Leiterbahnen, welche von einer gedruckten Schaltung auf der Leiterplatine kommen.

Aus der DE 197 20 678 C1 ist ein HF-Koaxial-Steckverbinderteil für den festen Anbau an eine Leiterplatte bekannt. An einem metallischen Gehäuse des HF-Koaxial-Steckverbinderteils sind Lötstifte sowie ein metallisches Steckteil in Form eines Koaxialsteckers bzw. einer Koaxialbuchse angeordnete. Die Lötstifte greifen beim Aufsetzen des Gehäuses mit seiner Unterseite auf eine die Leiterplatte in ihnen leiterplattenseitig zugeordnete elektrische Anschlüsse in Form kontaktierender Montagelöcher ein, in denen sie verlötet werden. Um mehrere derartige HF-Koaxial-Steckverbinderteile in ein Bauteil zu integrieren, ist es aus der DE 198 05 944 C1 bekannt, eine Steckerleiste vorzusehen, die mehrere Aufnahmeöffnungen aufweist. In jeweils eine Aufnahmeöffnung ist ein Koaxialwinkelsteckverbinder mit dessen Steckteilen eingesteckt und von der Steckerleiste gehaltert. Üblicherweise werden die HF-Steckverbinder zuerst in die Steckerleiste eingesetzt und dann wird die Steckerleiste auf die Platine aufgesetzt, so dass die Lötstifte aller HF-Steckverbinder in entsprechende Montagelöcher der Leiterplatte eingreifen bzw. Lötflächen aller HF-Steckverbinder an entsprechenden Lötpads auf der Leiterplatte angeordnet sind. Hierbei ergibt sich jedoch das Problem, dass die Lötstifte der mehreren in der Steckerleiste gehalterten HF-Steckverbinder an exakten Positionen ausgerichtet sein müssen, damit diese gleichzeitig beim Aufsetzten der Steckerleiste in die jeweiligen Montagelöcher greifen. Bei den Lötflächen der mehreren in der Steckerleiste gehalterten HF-Steckverbinder ergibt sich zusätzlich das Problem, dass diese nicht nur an der exakten Position sondern auch alle möglichst genau in der Ebene der Leiterplatte angeordnet sein müssen. Dies macht die Montage der HF-Steckverbinder an der Steckerleiste aufwändig und kostenintensiv. US-A-5405267 offenbart einen Leiterplattenmehrfachsteckverbinder mit den im allgemeinen Teil des Anspruchs 1 genannten Merkmalen.

Der Erfindung liegt die Aufgabe zugrunde, einen Leiterplattenmehrfachsteckverbinder der o.g. Art sowie eine Leiterplatte der o.g. Art hinsichtlich der Montage zu vereinfachen und gleichzeitig die elektrischen Eigenschaft zu verbessern.

Diese Aufgabe wird erfindungsgemäß durch ein Leiterplattenmehrfachsteckverbinder der o.g. Art mit den in Anspruch 1 gekennzeichneten Merkmalen und durch eine Leiterplatte der o.g. Art mit den in Anspruch 13 gekennzeichneten Merkmalen gelöst. Vorteilhafte Ausgestaltungen der Erfindung sind in den weiteren Ansprüchen beschrieben.

Bei einem Leiterplattenmehrfachsteckverbinder der o.g. Art ist es erfindungsgemäß vorgesehen, dass das Halterungsteil wenigstens eine erste Kontaktvorrichtung aufweist, welche derart angeordnet und ausgebildet ist, dass diese erste Kontaktvorrichtung einen elektrischen Kontakt zu wenigstens einem Kontaktelement eines Kontaktteiles herstellt, wobei das Halterungsteil wenigstens eine zweite Kontaktvorrichtung aufweist, welche mit wenigstens einer ersten Kontakteinrichtung elektrisch verbunden und zum Herstellen eines elektrischen Kontaktes mit einem Leiter auf der Leiterplatte ausgebildet ist.

Dies hat den Vorteil, dass die Funktion der elektrischen und mechanischen Kontaktierung des Kontaktteiles mit der Leiterplatte von den Kontaktelementen des Kontaktteils entkoppelt ist, so dass die Steckfunktion und die elektrische Kontaktierung funktionell voneinander getrennt sind. Hierdurch verschiebt sich die Notwendigkeit einer exakten Positionierung von Kontakten, die mit der Leiterplatte elektrisch zu verbinden sind, auf das Halterungsteil, was einfacher zu realisieren ist, als bei den Kontaktelementen der Kontaktteile. Mit anderen Worten stellt das Halterungsteil einen elektrischen Kontakt zwischen einem Kontaktelement eines Kontaktteils und einem Leiter der Leiterplatte her, so dass keine direkte elektrische Kontaktierung zwischen diesem Kontaktelement des Kontaktteils und dem Leiter der Leiterplatte mehr notwendig ist. Eine exakte Positionierung dieses Kontaktelementes des Kontaktteils ist nicht mehr notwendig, da die Funktion der elektrischen Kontaktierung für dieses eine oder mehrere Kontaktelemente von dem Halterungsteil übernommen wird.

Zweckmäßigerweise ist die zweite Kontaktvorrichtung des Halterungsteils derart angeordnet und ausgebildet, dass diese zweite Kontaktvorrichtung einen elektrischen Kontakt zu demjenigen Leiter auf der Leiterplatte herstellt, der mit demjenigen Kontaktelement des Kontaktteils elektrisch zu verbinden ist, welches mit derjenigen ersten Kontaktvorrichtung elektrisch verbunden ist, die mit dieser zweiten Kontaktvorrichtung elektrisch verbunden ist.

In einer bevorzugten Ausführungsform ist das Kontaktteil als HF-Steckverbinder mit einem Außenleiter und einem Innenleiter ausgebildet, wobei wenigstens ein Kontaktelement des Kontaktteils als Außenleiterkontakt und wenigstens ein weiteres Kontaktelement des Kontaktteils als Innenleiterkontakt ausgebildet ist. Hierbei ist die erste Kontaktvorrichtung des Halterungsteils bevorzugt mit allen Außenleiterkontakten der Kontaktteile elektrisch verbunden und die mit der ersten Kontaktvorrichtung elektrisch verbundene zweite Kontaktvorrichtung zum Herstellen eines elektrischen Kontaktes mit einem Außenleiter bzw. Masseleiter auf der Leiterplatte ausgebildet ist.

Eine besonders einfache und kostengünstige Herstellung und Montage bei gleichzeitig hoher und zuverlässig wiederholbarer Kontaktgüte für Hochfrequenzanwendungen erzielt man dadurch, dass die erste Kontaktvorrichtung als Klemmkontakt ausgebildet ist. Einen besonders hochwerteigen elektrischen Kontakt erzielt man dadurch, dass Kontaktflächen des Klemmkontaktes mit Nickel beschichtet sind.

Lokal begrenzte und definierte Kontaktpunkte zwischen den Leitern der Leiterplatte und der zweiten Kontaktvorrichtung des Halterungsteiles mit entsprechend vorbestimmtem Verlauf eines Stromflusses erzielt man dadurch, dass die zweite Kontaktvorrichtung des Halterungsteiles mehrere einzelne Erhebungen aufweist, die beabstandet voneinander an einer der Leiterplatte zugewandten Seite des Halterungsteiles ausgebildet sind.

Besonders gut lötbare Kontaktflächen zwischen dem Halterungsteil und der Leiterplatte erzielt man dadurch, dass Kontaktflächen der zweiten Kontaktvorrichtung des Halterungsteiles eine Oberfläche aus Zinn aufweisen.

Zweckmäßigerweise ist die zweite Kontaktvorrichtung des Halterungsteils einstückig mit dem Halterungsteil ausgebildet.

In einer bevorzugten Ausführungsform weist das Halterungsteil an einer der Leiterplatte zugewandten Seite wenigstens einen sich von dieser Seite erhebenden Stift zum Eingreifen in eine entsprechende Montageöffnung der Leiterplatte und mechanischen und/oder elektrischen Verbinden mit der Leiterplatte auf.

Zum zusätzlichen mechanischen Sichern des Halterungsteils an der Leiterplatte weist das Halterungsteil einen Befestigungsabschnitt zum mechanischen Verbinden des Halterungsteils mit der Leiterplatte auf. Der Befestigungsabschnitt weist beispielsweise eine Öffnung auf, welche zum Durchgreifen einer in die Leiterplatte eingeschraubten Schraube ausgebildet ist.

Bei einer Leiterplatte der o.g. Art ist es erfindungsgemäß vorgesehen, dass der Leiterplattenmehrfachsteckverbinder wie zuvor beschrieben ausgebildet ist.

Dies hat den Vorteil, dass die Funktion der elektrischen und mechanischen Kontaktierung des Kontaktteiles mit der Leiterplatte von den Kontaktelementen des Kontaktteils entkoppelt ist, so dass die Steckfunktion und die elektrische Kontaktierung funktionell voneinander getrennt sind. Hierdurch verschiebt sich die Notwendigkeit einer exakten Positionierung von Kontakten, die mit der Leiterplatte elektrisch zu verbinden sind, auf das Halterungsteil, was einfacher zu realisieren ist, als bei den Kontaktelementen der Kontaktteile.

Zweckmäßigerweise ist der Leiterplattenmehrfachsteckverbinder auf der Leiterplatte festgeschraubt.

Die Erfindung wird im Folgenden anhand der Zeichnung näher erläutert. Diese zeigt in:
- Fig. 1: eine bevorzugte Ausführungsform eines erfindungsgemäßen Leiterplattenmehrfachsteckverbinder in perspektivischer Ansicht mit einem noch nicht montierten Kontaktteil,
- Fig. 2: die bevorzugte Ausführungsform eines erfindungsgemäßen Leiterplattenmehrfachsteckverbinder gemäß Fig. 1 in perspektivischer Ansicht mit einem montierten Kontaktteil und
- Fig. 3: die bevorzugte Ausführungsform eines erfindungsgemäßen Leiterplattenmehrfachsteckverbinder gemäß Fig. 1 in perspektivischer Ansicht mit einem montierten Kontaktteil.

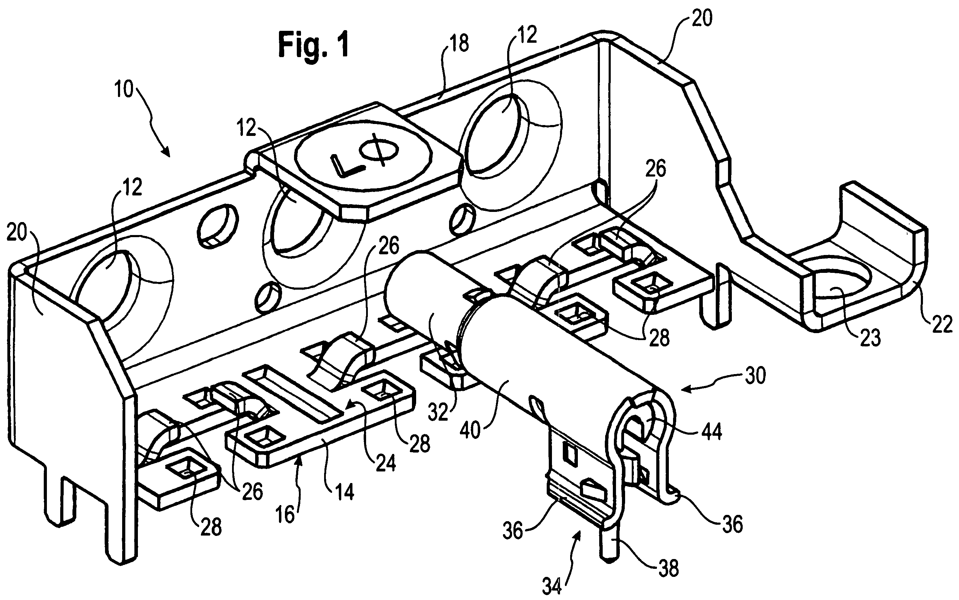

Die in Fig. 1 bis 3 dargestellte, bevorzugte Ausführungsform eines erfindungsgemäßen Leiterplattenmehrfachsteckverbinders zum Befestigen auf einer Leiterplatte (nicht dargestellt) umfasst ein Halterungsteil 10 mit drei Öffnungen 12, eine erste Wandung 14 mit einer der Leiterplatte zugewandten Leiterplattenseite 16 und eine zweite Wandung 18, in der die Öffnungen 12 ausgebildet sind. Das Halterungsteil 10 weist ferner Seitenteile 20 auf, die senkrecht zur ersten Wandung 14 sowie zur zweiten Wandung 18 angeordnet sind. An einem Seitenteil 20 ist ein Befestigungsabschnitt 22 mit Öffnung 23 zum mechanischen Verbinden des Halterungsteils 10 mit der Leiterplatte, beispielsweise mittels einer Schraubverbindung, ausgebildet. An einer der Leiterplattenseite 16 gegenüberliegenden Kontaktteilseite 24 der ersten Wandung 14 sind erste Kontaktvorrichtungen in Form von sich bogenförmig erhebenden Laschen 26 ausgebildet. An der Leiterplattenseite 16 der ersten Wandung 14 sind zweite Kontaktvorrichtungen in Form von sich in Richtung der Leiterplatte erhebenden Kontaktflächen 28 ausgebildet. Diese Kontaktflächen 28 kommen bei auf die Leiterplatte aufgesetztem Halterungsteil 10 auf entsprechenden Kontaktpads der Leiterplatte zu liegen und werden mit diesen Kontaktpads mittels einer Lötverbindung elektrisch verbunden. Das Halterungsteil ist derart ausgebildet, dass alle Kontaktflächen 28 mit einer Abweichung von weniger als 100µm innerhalb einer gemeinsamen Ebene liegen. Auf diese Weise ist eine gleichmäßige Kontaktierung von allen Kontaktflächen 28 mit den Kontaktpads der Leiterplatte sichergestellt. Das Halterungsteil 10 sowie die einstückig an diesem ausgebildeten Kontaktfläche 28 und sich bogenförmig erhebenden Laschen 26 sind vollständig aus einem elektrisch leitenden Werkstoff ausgebildet, so dass eine elektrisch leitende Verbindung zwischen allen sich bogenförmig erhebenden Laschen 26 und allen Kontaktflächen 28 vorhanden ist.

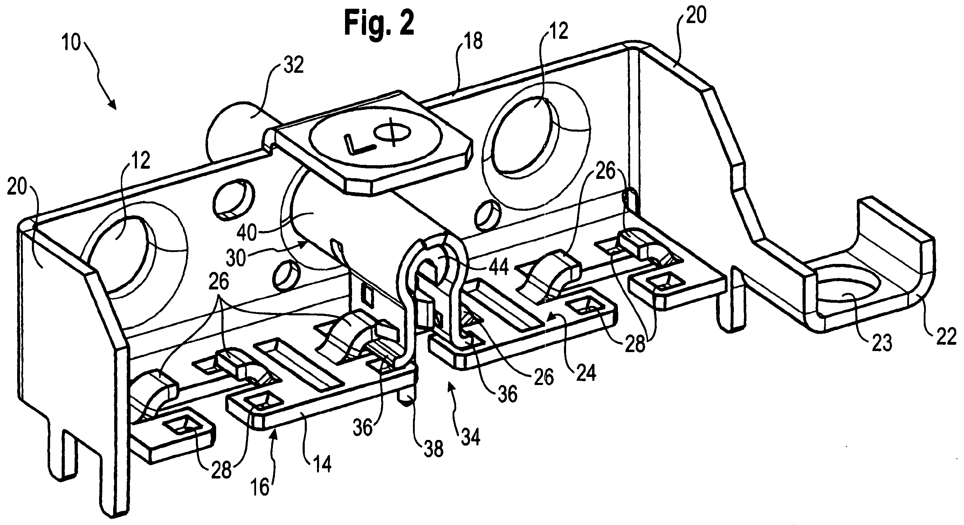

Der beispielhaft dargestellte Leiterplattenmehrfachsteckverbinder umfasst ferner drei Kontaktteile 30, von denen aus Gründen der Übersichtlichkeit lediglich eines dargestellt ist. Die Kontaktteile 30 sind als HF-Steckverbinder mit jeweils einem Steckteil 32 zum steckenden Verbinden mit einem komplementären Steckteil (nicht dargestellt) eines Steckverbinders (nicht dargestellt) ausgebildet. Jedes Steckteil 32 ist zum Eingriff in eine der Öffnungen 12 ausgebildet, wie in Fig. 2 dargestellt. Die Kontaktteile 30 sind mit deren jeweiligem Steckteil 32 in eine Öffnung 12 eingepresst.

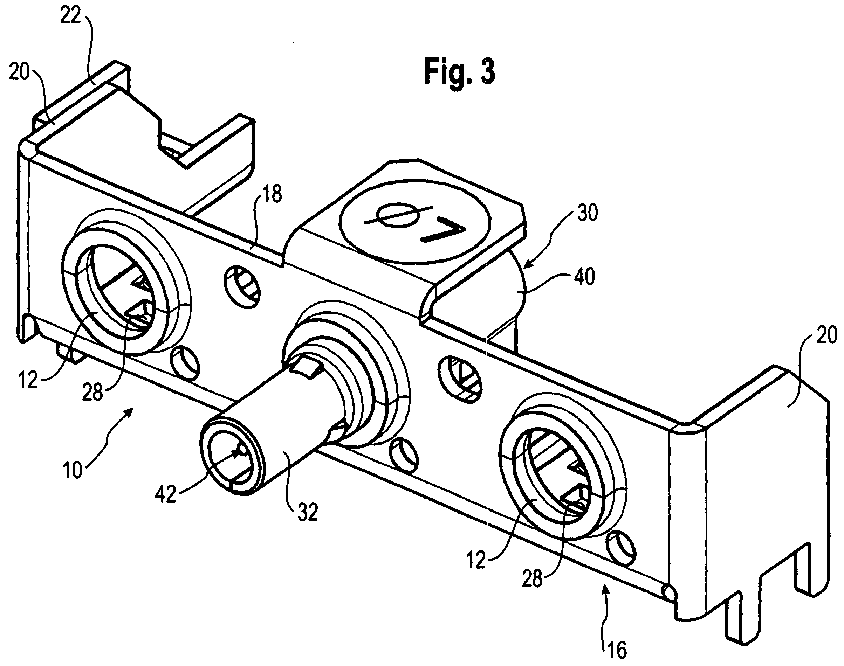

Jedes Kontaktteil 30 weist ferner eine der Leiterplatte zugewandet Seite 34 auf, an der Kontaktelemente 36, 38 angeordnet sind. In der beispielhaft dargestellten Ausführungsform ist ein erstes Kontaktelement 36 als ein Außenleiterkontakt und ein zweites Kontaktelement 38 als Innenleiterkontakt ausgebildet. Der Innenleiterkontakt 38 ist als sich in Richtung der Leiterplatte über die erste Wandung 14 des Halterungsteils 10 hinaus erstreckender Stift ausgebildet, der bei auf die Leiterplatte aufgesetztem Halterungsteil 10 in eine entsprechende Montageöffnung auf der Leiterplatte greift und dort beispielsweise mittels Löten mit einem Signalleiter der Leiterplatte elektrisch verbunden ist. Dieser Innenleiterkontakt 38 ist elektrisch mit einem Innenleiterteil 42 (Fig. 3) des Kontaktteils 30 verbunden, wobei sich dieses Innenleiterteil in das Steckteil 32 hinein erstreckt und mittels eines Isolators 44 (Fig. 1 und 2) innerhalb eines Außenleiterteils 40 des Kontaktteils 30 gehalten ist. Der Außenleiterkontakt 36 ist elektrisch mit dem Außenleiterteil 40 verbunden und ist unter die bogenförmigen Laschen 26 passend ausgebildet. Wie aus Fig. 2 ersichtlich, lassen sich die Außenleiterkontakte 36 des Kontaktteils 30 unter die freien Enden der bogenförmigen Laschen 26 schieben, so dass ein elektrischer Klemmkontakt zwischen dem Außenleiterkontakte 36 des Kontaktteils 30 und den bogenförmigen Laschen 26 hergestellt ist. Hierdurch ist gleichzeitig über das elektrisch leitende Halterungsteil 10 eine elektrisch leitende Verbindung zwischen dem Außenleiterkontakte 36 des Kontaktteils 30 und den Kontaktflächen 28 der ersten Wandung 14 des Halterungsteils 10 hergestellt.

Die erste Wandung 14 ist aus einem elektrisch leitenden Werkstoff hergestellt, so dass die bogenförmigen Laschen 26 elektrisch mit den Kontaktflächen 28 verbunden sind. Auf diese Weise stellt die erste Wandung 14 über die bogenförmigen Laschen 26 und die Kontaktflächen 28 einen elektrischen Kontakt zwischen den Außenleiterkontakten 36 und entsprechenden Masseleitern auf der Leiterplatte, die von den Kontaktflächen 28 elektrisch kontaktiert werden, her. Mit anderen Worten, muss diese elektrische Verbindung zwischen den Außenleiterkontakten 36 der Kontaktteile 30 nicht mehr direkt an der der Leiterplatte zugewandten Seite 34 der Kontaktteile 30 erfolgen, sondern diese elektrische Kontaktierung wird von dem Halterungsteil 10 übernommen. Hierdurch entfällt eine genaue Ausrichtung der der Leiterplatte zugewandten Seiten 34 von benachbarten Kontaktteile 30 in einer Ebene auf 0,1 mm genau.

Das Halterungsteil 10 ist als einstückiges Stanz-Biege-Teil mit einer Oberfläche aus Zinn ausgebildet. Dies erlaubt ein gutes Verlöten der Kontaktflächen 28 mit entsprechenden Kontaktpads auf der Leiterplatte. Das Kontaktteil 30 bzw. das Außenleiterteil 40 und das Innenleiterteil 42 sind dagegen bevorzugt mit einer Oberfläche aus Nickel ausgebildet, so dass sich am Steckteil 32 ein guter elektrischer Kontakt zum komplementären Steckverbinder bei niedrigen Steckkräften ergibt. Da an den elektrischen und mechanischen Kontaktstellen zwischen dem Außenleiterkontakt 36 und den sich bogenförmig erhebenden Laschen 26 ein Klemmkontakt und kein Lötkontakt ausgebildet ist, ist die Oberfläche aus schlecht lötbarem Nickel am Kontaktteil 30 nicht nachteilig.

Dieser erfindungsgemäße Leiterplattenmehrfachsteckverbinder bzw. Platinenstecker trennt somit funktionell das Steckinterface am Steckteil 32 von der gelöteten elektrischen Verbindung des Außenleiters 40 mit entsprechenden Masseleitern auf der Leitungsplatine. Hierdurch ist es möglich für das Steckinterface am Steckteil 32 einerseits und die gelöteten elektrischen Verbindung des Außenleiters 40 mit entsprechenden Masseleitern auf der Leitungsplatine andererseits unterschiedliche Beschichtungen zu verwenden. Der erfindungsgemäße Leiterplattenmehrfachsteckverbinder ist variabel bestückbar, d.h. die drei Kontaktteile 30 müssen nicht notwendigerweise identisch ausgebildet sein. Das System eignet sich insbesondere für 1-, 2-, 3- und 4-fach PCB-Stecker. Die stand-off planarität der Außenleiterkontaktierung ist auch bei Mehrfachsteckern innerhalb 0,1 mm einfach herzustellen, da diese elektrischen Kontakte von den Kontaktflächen 28 des Halterungsteils 10 hergestellt werden und nicht direkt von den Außenleiterkontakten 36 an der der Leiterplatte zugewandten Seite 34 der Kontaktteile 30.

Durch die Kontaktierung der Masseleiter der Leiterplatte mittels der Kontaktflächen 28 des Halterungsteils 10 ergeben sich örtlich definierte elektrische Kontaktstellen mit dementsprechend definierten Stromflusspfaden unabhängig von unvorhersehbar verlaufendem Lötzinn während des Lötvorganges. Letzteres würde sich ergeben, wenn die Leiterplattenseite 16 der ersten Wandung 14 eine an der Leiterplatte anliegende, vollständig ebene Fläche ausbilden würde.

Das Halterungsteil 10 weist an den Seitenteilen 20 wenigstens einen, in der beispielhaften Darstellung vier, sich in Richtung der Leiterplatte erhebenden Stift 46 zum Eingreifen in eine entsprechende Montageöffnung der Leiterplatte und mechanischen und/oder elektrischen Verbinden mit der Leiterplatte auf.

## Patentansprüche

1. Leiterplattenmehrfachsteckverbinder zum Befestigen auf einer Leiterplatte mit einem Halterungsteil (10) und mindestens zwei Kontaktteilen (30), die jeweils ein Steckteil (32) zum steckenden Verbinden mit einem komplementären Steckteil eines Steckverbinders aufweisen, wobei in dem Halterungsteil (10) für jedes Kontaktteil (30) eine Öffnung (12) ausgebildet ist und jedes Kontaktteil (30) mit dem Steckteil (32) durch eine der Öffnungen (12) greift und an dem Halterungsteil (10) mechanisch befestigt ist, wobei jedes Kontaktteil (30) an einer der Leiterplatte zugewanden Seite (34) mindestens ein Kontaktelement (36, 38) zum Herstellen eines elektrischen Kontaktes mit einem Leiter der Leiterplatte aufweist, wobei
das Halterungsteil (10) mindestens eine erste Kontaktvorrichtung (26) aufweist, welche derart angeordnet und ausgebildet ist, dass diese erste Kontaktvorrichtung (26) einen elektrischen Kontakt zu mindestens einem Kontaktelement (36) eines Kontaktteiles (30) herstellt, wobei das Halterungsteil (10) mindestens eine zweite Kontaktvorrichtung (28) aufweist, welche mit mindestens einer ersten Kontakteinrichtung (26) elektrisch verbunden und zum Herstellen eines elektrischen Kontaktes mit einem Leiter auf der Leiterplatte ausgebildet ist,
**dadurch gekennzeichnet,**
**dass** das Halterungsteil (10) als Stanz-Biegeteil ausgebildet ist, wobei die erste Kontaktvorrichtung (26) als eine sich bogenförmig erhebende Lasche einstückig mit dem Halterungsteil (10) derart ausgebildet ist, dass das Kontaktelement (36) des Kontaktteils (30) unter das freie Ende der bogenförmigen Lasche (26) geschoben einen elektrischen Klemmkontakt zwischen dem Kontaktelement (36) des Kontaktteils (30) und den bogenförmigen Laschen (26) herstellt.

2. Leiterplattenmehrfachsteckverbinder nach Anspruch 1, **dadurch gekennzeichnet, dass** die zweite Kontaktvorrichtung (28) des Halterungsteils (10) derart angeordnet und ausgebildet ist, dass diese zweite Kontaktvorrichtung (28) einen elektrischen Kontakt zu demjenigen Leiter auf der Leiterplatte herstellt, der mit demjenigen Kontaktelement (36) des Kontaktteils (30) elektrisch zu verbinden ist, welches mit derjenigen ersten Kontaktvorrichtung (26) elektrisch verbunden ist, die mit dieser zweiten Kontaktvorrichtung (28) elektrisch verbunden ist.

3. Leiterplattenmehrfachsteckverbinder nach Anspruch 1 oder 2, **dadurch gekennzeichnet, dass** das Kontaktteil (30) als HF-Steckverbinder mit einem Außenleiter (40) und einem Innenleiter (42) ausgebildet ist, wobei wenigstens ein Kontaktelement (36) des Kontaktteils (30) als Außenleiterkontakt und wenigstens ein weiteres Kontaktelement (38) des Kontaktteils (30) als Innenleiterkontakt ausgebildet ist.

4. Leiterplattenmehrfachsteckverbinder nach Anspruch 3, **dadurch gekennzeichnet, dass** die erste Kontaktvorrichtung (26) des Halterungsteils (10) mit allen Außenleiterkontakten (36) der Kontaktteile (30) elektrisch verbunden ist und die mit der ersten Kontaktvorrichtung (26) elektrisch verbundene zweite Kontaktvorrichtung (28) zum Herstellen eines elektrischen Kontaktes mit einem Außenleiter bzw. Masseleiter auf der Leiterplatte ausgebildet ist.

5. Leiterplattenmehrfachsteckverbinder nach wenigstens einem der vorhergehenden Ansprüche, **dadurch gekennzeichnet, dass** die erste Kontaktvorrichtung (26) als Klemmkontakt ausgebildet ist.

6. Leiterpiattenmehrfachsteckverbinder nach Anspruch 5, **dadurch gekennzeichnet, dass** Kontaktflächen des Klemmkontaktes (26) mit Nickel beschichtet sind.

7. Leiterplattenmehrfachsteckverbinder nach wenigstens einem der vorhergehenden Ansprüche, **dadurch gekennzeichnet, dass** die zweite Kontaktvorrichtung (28) des Halterungsteiles (10) mehrere einzelne Erhebungen aufweist, die beabstandet voneinander an einer der Leiterplatte zugewandten Seite (16) des Halterungsteiles (10) ausgebildet sind.

8. Leiterplattenmehrfachsteckverbinder nach wenigstens einem der vorhergehenden Ansprüche, **dadurch gekennzeichnet, dass** Kontaktflächen der zweiten Kontaktvorrichtung (28) des Halterungsteiles (10) eine Oberfläche aus Zinn aufweisen.

9. Leiterplattenmehrfachsteckverbinder nach wenigstens einem der vorhergehenden Ansprüche, **dadurch gekennzeichnet, dass** die zweite Kontaktvorrichtung (26, 28) des Halterungsteils (10) einstückig mit dem Halterungsteil (10) ausgebildet sind.

10. Leiterplattenmehrfachsteckverbinder nach wenigstens einem der vorhergehenden Ansprüche, **dadurch gekennzeichnet, dass** das Halterungsteil (10) an einer der Leiterplatte zugewandten Seite (16) wenigstens einen sich von dieser Seite erhebenden Stift (46) zum Eingreifen in eine entsprechende Montageöffnung der Leiterplatte und mechanischen und/oder elektrischen Verbinden mit der Leiterplatte aufweist.

11. Leiterplattenmehrfachsteckverbinder nach wenigstens einem der vorhergehenden Ansprüche, **dadurch gekennzeichnet, dass** das Halterungsteil (10) einen Befestigungsabschnitt (22) zum mechanischen Verbinden des Halterungsteils (10) mit der Leiterplatte aufweist.

12. Leiterplattenmehrfachsteckverbinder nach Anspruch 11, **dadurch gekennzeichnet, dass** der Befestigungsabschnitt (22) eine Öffnung (23) aufweist, welche zum Durchgreifen einer in die Leiterplatte eingeschraubten Schraube ausgebildet ist.

13. Leiterplatte mit einer elektronischen Schaltung und einem auf der Leiterplatte angeordneten und elektrisch mit der elektronischen Schaltung verbundenem Leiterplattenmehrfachsteckverbinder,
**dadurch gekennzeichnet,**
**dass** der Leiterplattenmehrfachsteckverbinder gemäß wenigstens einem der vorhergehenden Ansprüche ausgebildet ist.

14. Leiterplatte nach Anspruch 13, **dadurch gekennzeichnet, dass** der Leiterplattenmehrfachsteckverbinder auf der Leiterplatte festgeschraubt ist.

## Claims

1. Multiple plug-in connector for printed circuit boards for fastening to a printed circuit board, having a mounting part (10) and having at least two contact sections (30) which each have a plug-in part (32) for connection by plugging-in to a complementary mating part of a plug-in connector, an opening (12) being formed for each contact section (30) in the mounting part (10) and each contact section (30) passing through one of the openings (12) by its plug-in part (32) and being fastened to the mounting part (10) mechanically, each contact section (30) having, on a side (34) adjacent the printed circuit board, at least one contact member (36, 38) for making electrical contact with a conductor on the printed circuit board, the mounting part (10) having at least one first contact device (26) which is so arranged and formed that said first contact device (26) makes electrical contact with at least one contact member (36) of a contact section (30), the mounting part (10) having at least one second contact device (28) which is electrically connected to at least one first contact device (26) and which is designed to make electrical contact with a conductor on the printed circuit board, **characterised in that** the mounting part (10) takes the form of a stamped/punched and bent part, the first contact device (26) being formed in one piece with the mounting part (10) in the form of a tab rising in an arc in such a way that the contact member (36) of the contact section (30), when slid under the free end of the arcuate tab (26), makes clamped electrical contact between the contact member (36) of the contact section (30) and the arcuate tabs (26).

2. Multiple plug-in connector for printed circuit boards according to claim 1, **characterised in that** the second contact device (28) of the mounting part (10) is so arranged and formed that said second contact device (28) makes electrical contact with that conductor on the printed circuit board which has to be electrically connected to that contact member (36) of the contact section (30) which is electrically connected to that first contact device (26) which is electrically connected to said second contact device (28).

3. Multiple plug-in connector for printed circuit boards according to claim 1 or 2, **characterised in that** the contact section (30) takes the form of an RF plug-in connector having an outer conductor (40) and a centre conductor (42), at least one contact member (36) of the contact section (30) taking the form of an outer-conductor contact and at least one other contact member (38) of the contact section (30) taking the form of a centre-conductor contact.

4. Multiple plug-in connector for printed circuit boards according to claim 3, **characterised in that** the first contact device (26) of the mounting part (10) is electrically connected to all the outer-conductor contacts (36) of the contact sections (30) and the second contact device (28), which is electrically connected to the first contact device (26), is designed to make electrical contact with an outer conductor, i.e. an earth conductor, on the printed circuit board.

5. Multiple plug-in connector for printed circuit boards according to at least one of the preceding claims, **characterised in that** the first contact device (26) takes the form of a clamping contact.

6. Multiple plug-in connector for printed circuit boards according to claim 5, **characterised in that** contact areas of the clamping contact (26) are coated with nickel.

7. Multiple plug-in connector for printed circuit boards according to at least one of the preceding claims, **characterised in that** the second contact device (28) of the mounting part (10) has a plurality of individual elevations which are formed on a side (16) of the mounting part (10) adjacent the printed circuit board in such a way as to be spaced apart from one another.

8. Multiple plug-in connector for printed circuit boards according to at least one of the preceding claims, **characterised in that** contact areas of the second contact device (28) of the mounting part (10) have a finish of tin.

9. Multiple plug-in connector for printed circuit boards according to at least one of the preceding claims, **characterised in that** the second contact device (26, 28) of the mounting part (10) are formed in one piece with the mounting part (10).

10. Multiple plug-in connector for printed circuit boards according to at least one of the preceding claims, **characterised in that** the mounting part (10) has, on a side (16) adjacent the printed circuit board, at least one pin (46) which projects from this side, to engage in a corresponding mounting opening in the printed circuit board and to make a mechanical and/or electrical connection to the printed circuit board.

11. Multiple plug-in connector for printed circuit boards according to at least one of the preceding claims, **characterised in that** the mounting part (10) has a fastening portion (22) to connect the mounting part (10) mechanically to the printed circuit board.

12. Multiple plug-in connector for printed circuit boards according to claim 11, **characterised in that** the fastening portion (22) has an opening (23) which is designed to have a screw screwed into the printed circuit board pass through it.

13. Printed circuit board having an electronic circuit and having a multiple plug-in connector for printed circuit boards which is arranged on the printed circuit board and which is electrically connected to the electronic circuit, **characterised in that** the multiple plug-in connector for printed circuit boards is designed in accordance with at least one of the preceding claims.

14. Printed circuit board according to claim 13, **characterised in that** the multiple plug-in connector for printed circuit boards is screwed solidly to the printed circuit board.

## Revendications

1. Connecteur enfichable multiple pour carte à circuits, à fixer sur une carte à circuits, comprenant une partie de maintien (10) et au moins deux parties de contact (30), qui comprennent chacune une partie d'enfichage (32) pour la connexion par enfichage avec une partie d'enfichage complémentaire d'un connecteur enfichable, dans lequel une ouverture (12) est réalisée dans la partie de maintien (10) pour chaque partie de contact (30), et chaque partie de contact (30) s'engage avec la partie d'enfichage (32) à travers l'une des ouvertures (12) et est fixée mécaniquement sur la partie de maintien (10), dans lequel chaque partie de contact (30) comprend, sur un côté (34) tourné vers la carte à circuits, au moins un élément de contact (36, 38) pour établir un contact électrique avec un conducteur de la carte à circuits, dans lequel
la partie de maintien (10) comprend au moins un premier dispositif de contact (26), qui est agencé et réalisé de telle manière que ce premier dispositif de contact (26) établit un contact électrique avec au moins un élément de contact (36) d'une partie de contact (30), et la partie de maintien (10) comprend au moins un second dispositif de contact (28), qui est connecté électriquement avec au moins un premier système de contact (26) et est réalisé pour établir un contact électrique avec un conducteur sur la carte à circuits,
**caractérisé en ce que**
la partie de maintien (10) est réalisée sous forme de pièce poinçonnée/pliée, dans laquelle le premier dispositif de contact (26) est réalisé comme une patte qui se dresse en formant un arc et d'un seul tenant avec la partie de maintien (10) de telle manière que l'élément de contact (36) de la partie de contact (30), enfilé au-dessous de l'extrémité libre de la patte (26) en forme d'arc, établit un contact électrique par serrage entre l'élément de contact (36) de la partie de contact (30) et la patte (26) en forme d'arc.

2. Connecteur enfichable multiple pour carte à circuits selon la revendication 1, **caractérisé en ce que** le second dispositif de contact (28) de la partie de maintien (10) est agencé et réalisé de telle façon que ce second dispositif de contact (28) établit un contact électrique avec celui des conducteurs sur la carte à circuits qu'il s'agit de connecter électriquement avec l'élément de contact (36) de la partie de contact (30) qui est connectée électriquement avec le premier dispositif de contact (26) qui est connecté électriquement avec ce second dispositif de contact (28).

3. Connecteur enfichable multiple pour carte à circuits selon la revendication 1 ou 2, **caractérisé en ce que** la partie de contact (30) est réalisée sous forme de connecteur enfichable HF avec un conducteur extérieur (40) et un conducteur intérieur (42), et au moins un élément de contact (36) de la partie de contact (30) est réalisé sous forme de contact de conducteur extérieur, et au moins un autre élément de contact (38) de la partie de contact (30) est ré alisé sous forme de contact de conducteur intérieur.

4. Connecteur enfichable multiple pour carte à circuits selon la revendication 3, **caractérisé en ce que** le premier dispositif de contact (26) de la partie de maintien (10) est connecté électriquement avec tous les contacts de conducteurs extérieurs (36) des parties de contact (30), et le second dispositif de contact (28) connecté électriquement avec le premier dispositif de contact (26) est réalisé pour établir un contact électrique avec un conducteur extérieur ou respectivement un conducteur de masse sur la carte à circuits.

5. Connecteur enfichable multiple pour carte à circuits selon l'une au moins des revendications précédentes, **caractérisé en ce que** le premier dispositif de contact (26) est réalisé sous forme de contact à serrage.

6. Connecteur enfichable multiple pour carte à circuits selon la revendication 5, **caractérisé en ce que** les surfaces de contact du contact à serrage (26) sont revêtues de nickel.

7. Connecteur enfichable multiple pour carte à circuits selon l'une au moins des revendications précédentes, **caractérisé en ce que** le second dispositif de contact (28) de la partie de maintien (10) comporte plusieurs bossages individuels, qui sont réalisés à distance les uns des autres sur un côté (16), tourné vers la carte à circuits, de la partie de maintien (10).

8. Connecteur enfichable multiple pour carte à circuits selon l'une au moins des revendications précédentes, **caractérisé en ce que** des surfaces de contact du second dispositif de contact (28) de la partie de maintien (10) comportent une surface en zinc.

9. Connecteur enfichable multiple pour carte à circuits selon l'une au moins des revendications précédentes, **caractérisé en ce que** le second dispositif de contact (26, 28) de la partie de maintien (10) est réalisée d'une seule pièce avec la partie de maintien (10).

10. Connecteur enfichable multiple pour carte à circuits selon l'une au moins des revendications précédentes, **caractérisé en ce que** la partie de maintien (10) comporte, sur un côté (16) tourné vers la carte à circuits, au moins une tige (46) qui se dresse depuis ce côté pour s'engager dans une ouverture de montage correspondante de la carte à circuits et pour établir une liaison mécanique et/ou électrique avec la carte à circuits.

11. Connecteur enfichable multiple pour carte à circuits selon l'une au moins des revendications précédentes, **caractérisé en ce que** la partie de maintien (10) comprend une portion de fixation (22) pour la liaison mécanique de la partie de maintien (10) avec la carte à circuits.

12. Connecteur enfichable multiple pour carte à circuits selon la revendication 11, **caractérisé en ce que** la portion de fixation (22) comporte une ouverture (23) qui est réalisée pour la traversée d'une vis vissée dans la carte à circuits.

13. Carte à circuits comportant un circuit électronique et un connecteur enfichable multiple pour carte à circuits agencé sur la carte à circuits et connecté électriquement avec le circuit électronique,
**caractérisée en ce que** le connecteur enfichable multiple pour carte à circuits est réalisé selon l'une au moins des revendications précédentes.

14. Carte à circuits selon la revendication 13, **caractérisée en ce que** le connecteur enfichable multiple pour carte à circuits est fermement vissé sur la carte à circuits.
